# EUROPEAN PATENT APPLICATION

(11) **EP 3 767 391 A1**
(43) Date of publication of application: **20.01.2021**
(21) Application number: 19186820.7
(22) Date of filing: 17.07.2019
(51) Int. Cl.: G03F 7/20

(54) **SUB-FIELD CONTROL OF A LITHOGRAPHIC PROCESS AND ASSOCIATED APPARATUS**

(71) Applicant: ASML Netherlands B.V., 5500 AH Veldhoven (NL)
(72) Inventor: SMORENBERG, Pieter Gerardus Jacobus, 5500 AH Veldhoven (NL); SAPUTRA, Putra, 5500 AH Veldhoven (NL); DERWIN, Paul, 5500 AH Veldhoven (NL); ELBATTAY, Khalid, 5500 AH Veldhoven (NL)
(74) Representative: ASML Netherlands B.V.

(57) **Abstract**

Disclosed is a method for determining an intra-field correction for sub-field control of a lithographic process for exposing a pattern on an exposure field of a substrate, the exposure field comprising a plurality of sub-fields. The method comprises obtaining a database comprising intra-field fingerprint data linked with historic lithographic apparatus metrology data, determining an estimate for an intra-field fingerprint from lithographic apparatus metrology data and said database; and determining the intra-field correction for the lithographic process based on the estimated intra-field fingerprint.

## Description

### BACKGROUND

### Field of the Invention

The present invention relates to methods and apparatus for applying patterns to a substrate in a lithographic process and/or measuring said patterns.

### Background

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In order to monitor the lithographic process, parameters of the patterned substrate are measured. Parameters may include, for example, the overlay error between successive layers formed in or on the patterned substrate and critical linewidth (CD) of developed photosensitive resist. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Examples of known scatterometers include angle-resolved scatterometers of the type described in US2006033921A1 and US2010201963A1. The targets used by such scatterometers are relatively large, e.g., 40µm by 40µm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark-field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Currently the overlay error is controlled and corrected by means of correction models described for example in US2013230797A1. Advanced process control techniques have been introduced in recent years and use measurements of metrology targets applied to substrates alongside the applied device pattern. These targets allow overlay to be measured using a high-throughput inspection apparatus such as a scatterometer, and the measurements can be used to generate corrections that are fed back into the lithographic apparatus when patterning subsequent substrates. Examples of advanced process control (APC) are described for example in US2012008127A1. The inspection apparatus may be separate from the lithographic apparatus. Within the lithographic apparatus wafer correction models are conventionally applied based on measurement of overlay targets provided on the substrate, the measurements being as a preliminary step of every patterning operation. The correction models nowadays include higher order models, to correct for non-linear distortions of the wafer. The correction models may also be expanded to take into account other measurements and/or calculated effects such as thermal deformation during a patterning operation

While the use of higher order models may be able take into account more effects, however, such models may be of limited use, if the patterning apparatus itself does not provide control of corresponding parameters during patterning operations. Furthermore, even advanced correction models may not be sufficient or optimized to correct for certain overlay errors.

It would be desirable to improve such process control methods by, for example, addressing at least one of the issues highlighted above.

### SUMMARY OF THE INVENTION

In a first aspect of the invention, there is provided a method for determining an intra-field correction for sub-field control of a lithographic process for exposing a pattern on an exposure field of a substrate, the exposure field comprising a plurality of sub-fields, the method comprising: obtaining a database comprising intra-field fingerprint data linked with historic lithographic apparatus metrology data; determining an estimate for an intra-field fingerprint from lithographic apparatus metrology data and said database; and determining the intra-field correction for the lithographic process based on the estimated intra-field fingerprint.

In a second aspect of the invention, there is provided a method for determining an intra-field correction for sub-field control of a lithographic process for exposing a pattern on an exposure field of a substrate, the exposure field comprising a plurality of sub-fields, the method comprising: performing an optimization to determine the intra-field correction, said optimization being such that it maximizes the number of said sub-fields which are within specification.

In a third aspect of the invention, there is provided a method for determining an intra-field correction for sub-field control of a manufacturing process comprising a lithographic process for exposing a pattern on an exposure field of a substrate, the exposure field comprising a plurality of sub-fields, the manufacturing process comprising at least one additional processing step, the method comprising performing an optimization to determine the intra-field correction, said optimization comprising co-optimizing in terms of at least one lithographic parameter relating to the lithographic process and at least one process parameter relating to the at least one additional processing step.

In a fourth aspect of the invention, there is provided a method for determining an intra-field correction for sub-field control of a lithographic process for exposing a pattern on an exposure field of a substrate in a number of layers forming a stack, the exposure field comprising a plurality of sub-fields, the method comprising constructing a physical and/or empirical thru-stack model which describes how a parameter of interest, propagates from layer to layer through the stack.

In a fifth aspect of the invention, there is provided a method for determining an intra-field correction for sub-field control of a lithographic process for exposing a pattern on an exposure field of a substrate, the exposure field comprising a plurality of sub-fields, the method comprising: determining a sensitivity metric describing the sensitivity of a correction to input data used to determine the correction and/or the layout of said pattern; and determining said intra-field correction for sub-field control based on said sensitivity metric.

Also disclosed is a computer program comprising program instructions operable to perform the method of any of the above aspects when run on a suitable apparatus.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
Figure 1 depicts a lithographic apparatus together with other apparatuses forming a production facility for semiconductor devices;
Figure 2 depicts a schematic representation of holistic lithography, representing a cooperation between three key technologies to optimize semiconductor manufacturing;
Figure 3 shows exemplary sources of processing parameters;
Figure 4 is a graph of overlay against field position, showing the effect of intra-die stress for a particular manufacturing process; and
Figure 5 is a flow diagram of a method according to an embodiment of the invention.

### DETAILED DESCRIPTION

Before describing embodiments of the invention in detail, it is instructive to present an example environment in which embodiments of the present invention may be implemented.

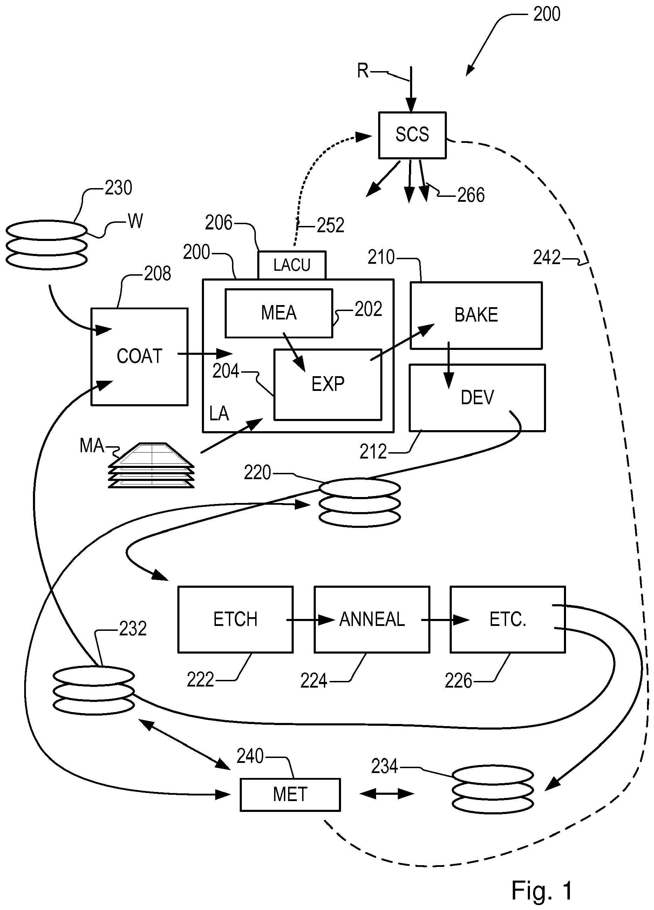

Figure 1 at 200 shows a lithographic apparatus LA as part of an industrial production facility implementing a high-volume, lithographic manufacturing process. In the present example, the manufacturing process is adapted for the manufacture of for semiconductor products (integrated circuits) on substrates such as semiconductor wafers. The skilled person will appreciate that a wide variety of products can be manufactured by processing different types of substrates in variants of this process. The production of semiconductor products is used purely as an example which has great commercial significance today.

Within the lithographic apparatus (or "litho tool" 200 for short), a measurement station MEA is shown at 202 and an exposure station EXP is shown at 204. A control unit LACU is shown at 206. In this example, each substrate visits the measurement station and the exposure station to have a pattern applied. In an optical lithographic apparatus, for example, a projection system is used to transfer a product pattern from a patterning device MA onto the substrate using conditioned radiation and a projection system. This is done by forming an image of the pattern in a layer of radiation-sensitive resist material.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. The patterning MA device may be a mask or reticle, which imparts a pattern to a radiation beam transmitted or reflected by the patterning device. Well-known modes of operation include a stepping mode and a scanning mode. As is well known, the projection system may cooperate with support and positioning systems for the substrate and the patterning device in a variety of ways to apply a desired pattern to many target portions across a substrate. Programmable patterning devices may be used instead of reticles having a fixed pattern. The radiation for example may include electromagnetic radiation in the deep ultraviolet (DUV) or extreme ultraviolet (EUV) wavebands. The present disclosure is also applicable to other types of lithographic process, for example imprint lithography and direct writing lithography, for example by electron beam.

The lithographic apparatus control unit LACU which controls all the movements and measurements of various actuators and sensors to receive substrates W and reticles MA and to implement the patterning operations.. LACU also includes signal processing and data processing capacity to implement desired calculations relevant to the operation of the apparatus. In practice, control unit LACU will be realized as a system of many sub-units, each handling the real-time data acquisition, processing and control of a subsystem or component within the apparatus.

Before the pattern is applied to a substrate at the exposure station EXP, the substrate is processed in at the measurement station MEA so that various preparatory steps may be carried out. The preparatory steps may include mapping the surface height of the substrate using a level sensor and measuring the position of alignment marks on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to print product features at the correct locations with very high accuracy. The apparatus may be of a so-called dual stage type which has two substrate tables, each with a positioning system controlled by the control unit LACU. While one substrate on one substrate table is being exposed at the exposure station EXP, another substrate can be loaded onto the other substrate table at the measurement station MEA so that various preparatory steps may be carried out. The measurement of alignment marks is therefore very time-consuming and the provision of two substrate tables enables a substantial increase in the throughput of the apparatus. If the position sensor IF is not capable of measuring the position of the substrate table while it is at the measurement station as well as at the exposure station, a second position sensor may be provided to enable the positions of the substrate table to be tracked at both stations. Lithographic apparatus LA may for example is of a so-called dual stage type which has two substrate tables and two stations - an exposure station and a measurement station- between which the substrate tables can be exchanged.

Within the production facility, apparatus 200 forms part of a "litho cell" or "litho cluster" that contains also a coating apparatus 208 for applying photosensitive resist and other coatings to substrates W for patterning by the apparatus 200. At an output side of apparatus 200, a baking apparatus 210 and developing apparatus 212 are provided for developing the exposed pattern into a physical resist pattern. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system SCS, which also controls the lithographic apparatus via lithographic apparatus control unit LACU. Thus, the different apparatus can be operated to maximize throughput and processing efficiency. Supervisory control system SCS receives recipe information R which provides in great detail a definition of the steps to be performed to create each patterned substrate.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a post-etch annealing step. Further physical and/or chemical processing steps are applied in further apparatuses, 226, etc.. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the lithographic apparatus.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other lithography apparatuses, as just mentioned, and may even be performed in different types of lithography apparatus. For example, some layers in the device manufacturing process which are very demanding in parameters such as resolution and overlay may be performed in a more advanced lithography tool than other layers that are less demanding. Therefore some layers may be exposed in an immersion type lithography tool, while others are exposed in a 'dry' tool. Some layers may be exposed in a tool working at DUV wavelengths, while others are exposed using EUV wavelength radiation.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which litho cell LC is located also includes metrology system which receives some or all of the substrates W that have been processed in the litho cell. Metrology results are provided directly or indirectly to the supervisory control system SCS. If errors are detected, adjustments may be made to exposures of subsequent substrates, especially if the metrology can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Also shown in Figure 1 is a metrology apparatus 240 which is provided for making measurements of parameters of the products at desired stages in the manufacturing process. A common example of a metrology station in a modern lithographic production facility is a scatterometer, for example a dark-field scatterometer, an angle-resolved scatterometer or a spectroscopic scatterometer, and it may be applied to measure properties of the developed substrates at 220 prior to etching in the apparatus 222. Using metrology apparatus 240, it may be determined, for example, that important performance parameters such as overlay or critical dimension (CD) do not meet specified accuracy requirements in the developed resist. Prior to the etching step, the opportunity exists to strip the developed resist and reprocess the substrates 220 through the litho cluster. The metrology results 242 from the apparatus 240 can be used to maintain accurate performance of the patterning operations in the litho cluster, by supervisory control system SCS and/or control unit LACU 206 making small adjustments over time, thereby minimizing the risk of products being made out-of-specification, and requiring re-work.

Additionally, metrology apparatus 240 and/or other metrology apparatuses (not shown) can be applied to measure properties of the processed substrates 232, 234, and incoming substrates 230. The metrology apparatus can be used on the processed substrate to determine important parameters such as overlay or CD.

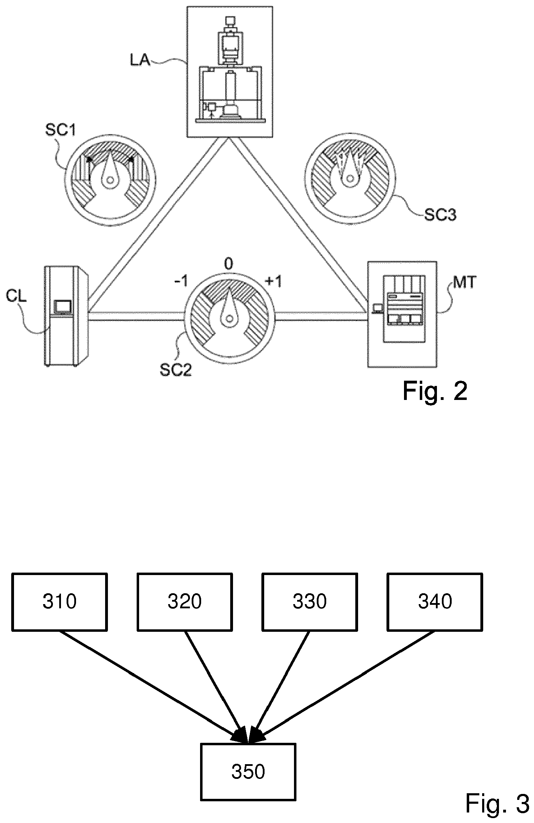

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 2. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 2 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 2 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 2 by the multiple arrows in the third scale SC3).

Various techniques may be used to improve the accuracy of reproduction of patterns onto a substrate. Accurate reproduction of patterns onto a substrate is not the only concern in the production of ICs. Another concern is the yield, which generally measures how many functional devices a device manufacturer or a device manufacturing process can produce per substrate. Various approaches can be employed to enhance the yield. One such approach attempts to make the production of devices (e.g., imaging a portion of a design layout onto a substrate using a lithographic apparatus such as a scanner) more tolerant to perturbations of at least one of the processing parameters during processing a substrate, e.g., during imaging of a portion of a design layout onto a substrate using a lithographic apparatus. The concept of overlapping process window (OPW) is a useful tool for this approach. The production of devices (e.g., ICs) may include other steps such as substrate measurements before, after or during imaging, loading or unloading of the substrate, loading or unloading of a patterning device, positioning of a die underneath the projection optics before exposure, stepping from one die to another, etc. Further, various patterns on a patterning device may have different process windows (i.e., a space of processing parameters under which a pattern will be produced within specification). Examples of pattern specifications that relate to a potential systematic defect include checks for necking, line pull back, line thinning, CD, edge placement, overlapping, resist top loss, resist undercut and/or bridging. The process window of all or some (usually patterns within a particular area) of the patterns on a patterning device may be obtained by merging (e.g., overlapping) process windows of each individual pattern. The process window of these patterns is thus called an overlapping process window. The boundary of the OPW may contain boundaries of process windows of some of the individual patterns. In another words, these individual patterns limit the OPW. These individual patterns can be referred to as "hot spots" "critical features" or "process window limiting patterns (PWLPs)," which are used interchangeably herein. When controlling a lithography process, it is possible, and typically economical, to focus on the hot spots. When the hot spots are not defective, it is likely that all the patterns are not defective. The imaging becomes more tolerant to perturbations when values of the processing parameters are closer to the OPW if the values of the processing parameters are outside the OPW, or when the values of the processing parameters are farther away from the boundary of the OPW if the values of the processing parameters are inside the OPW.

Figure 3 shows exemplary sources of processing parameters 350. One source may be data 310 of the processing apparatus, such as parameters of the source, projection optics, substrate stage, etc. of a lithography apparatus, of a track, etc. Another source may be data 320 from various substrate metrology tools, such as a substrate height map, a focus map, a critical dimension uniformity (CDU) map, etc. Data 320 may be obtained before the applicable substrate was subject to a step (e.g., development) that prevents reworking of the substrate. Another source may be data 330 from one or more patterning device metrology tools, patterning device CDU map, patterning device (e.g., mask) film stack parameter variation, etc. Yet another source may be data 340 from an operator of the processing apparatus.

Certain components of overlay (or other parameter of interest) on each substrate will be truly random in nature. However, other components will be systematic in nature, whether their cause is known or not. Where similar substrates are subject to similar patterns of overlay error, the patterns of error may be referred to as "fingerprints" of the lithographic process. Overlay errors can broadly be categorized into two distinct groups:
1) contributions which vary across an entire substrate are known in the art as inter-field fingerprints.
2) contributions which vary similarly across each target portion (field) of a substrate are known in the art as intra-field fingerprints.

Control of the lithographic process are typically based on measurements fed back or fed forward and then modelled using, for example the inter-field (across-substrate fingerprint) or intra-field (across-field fingerprint) models. United States Patent Application 20180292761, which is incorporated herein by reference, describes a control method for controlling a performance parameter such as overlay at a sub-field level using an advanced correction model. Another control method using sub-field control is described in European Patent Application EP3343294A1, which is also incorporated herein by reference.

However, while an advanced correction model may, for example, include 20-30 parameters, lithographic apparatuses (the term "scanners" will be used throughout the description for brevity) currently in use may not have actuators which correspond to one or more of the parameters. Hence, only a subset of the entire set of parameters of the model can be used at any given time. Additionally, as the advanced models require many measurements, it is not desirable to use these models in all situations, since the time required to perform the necessary measurements reduces throughput.

Some of the main contributors to overlay errors include, but are not limited to, the following:
scanner-specific errors: these may arise from the various subsystems of the scanner used during exposure of the substrate, in effect creating a scanner-specific fingerprint;
process induced wafer deformation: the various processes performed on the substrates may deform the substrate or wafer;
illumination setting differences: these are caused by the settings of the illumination system, such as the shape of the aperture, lens actuator positioning, etc.;
heating effects - heating induced effects will differ between various sub-fields of a substrate, in particular for substrates wherein the various sub-fields include different types of components or structures;
reticle writing errors: errors may be present already in the patterning device due to limitations in its manufacture; and
topography variations: substrates may have topography (height) variations, in particular around the edges of wafers.

Modeling overlay error of individual sub-fields of a field (e.g., at die level or other functional area level) can be carried out instead of modeling the overlay error of the field in its entirety, or it can be modeled in addition to modeling the field in its entirety. While the latter requires more processing time, since both the field as well as the sub-fields within it are modeled, it allows for the correction of error sources which relate to a particular sub-field only as well as error sources which relate to the entirety of the field. Other combinations, such as modeling the entire field and only certain sub-fields, are of course possible.

Even where an error is modelled sufficiently, actuation of a resultant correction also presents difficulties. Some corrections simply cannot be actuated effectively using the available control parameters (control knobs). Additionally, while other corrections may be actuatable, actually doing so may result in undesirable side effects. Essentially, due to dynamic and control limitations and sensitivities, there is a limit on what the scanner can actually do to implement a correction.

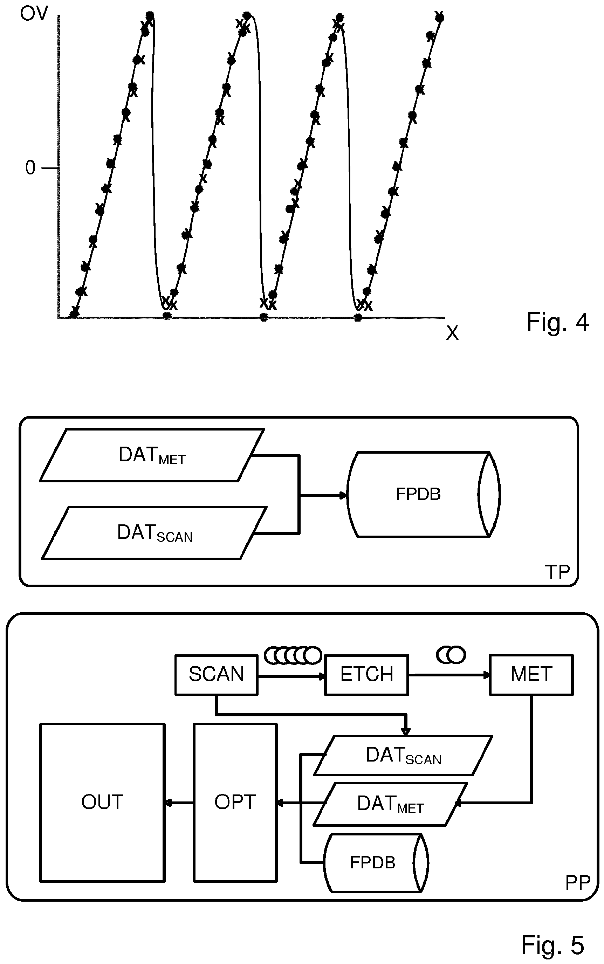

Figure 4 illustrates a specific example of an intra-field overlay fingerprint which presents difficulty in actuating correction. It shows a graph of overlay OV (y-axis) against direction X (or Y). Each cross represents a measured overlay value, and each dot is a necessary corresponding compensating correction. The fitted line is a (near ideal) correction profile, which is fitted to the corrections (dots). The saw tooth pattern exhibited in the overlay fingerprint is evident; each section through which the overlay varies substantially linearly with X being a single die (the graph representing overlay measurements across 4 dies). The correction profile follows (and therefore compensates for) the overlay fingerprint. Such a fingerprint is seen as a result of the large stresses induced by a large stack, e.g., as used in a 3D-NAND or DRAM process for example. This stress manifests itself both at wafer level (causing severe wafer warp) as well as at die level. At die level, the overlay fingerprint comprises a magnification inside each die. Since there are multiple dies within an exposure field, the resultant field overlay fingerprint exhibits the sawtooth pattern shown (typically at a scale of tens of nm). Depending on the orientation of the device, the pattern can either be through-slit or through-scan. Regardless of the orientation, the overlay cannot be corrected with available models and actuators. In particular, actuation of a correction for such an extreme pattern is not possible within the scanner alone.

While the embodiments herein will be described specifically in terms of overlay or edge placement error (EPE) which manifests as a sawtooth pattern or fingerprint (e.g., caused by intra-die stress in the 3D-NAND or DRAM process, as illustrated in Figure 4), it should be appreciated that it can be used to correct any other higher-order overlay, EPE or focus fingerprint.

In order to optimally correct the overlay fingerprint as depicted in Figure 4 it is important to be able to adjust the scanner at a spatial scale which is smaller than the pitch of a periodic profile, for example smaller than one "saw tooth' of the repeating saw tooth profile of Figure 4. Such an individual saw tooth area is typically associated with a cell structure within an individual die. Hence the interface to the scanner should allow the definition of separately controllable areas within an exposure field. This concept is referred to as a sub-field control interface; an example of this disclosed in the aforementioned European Patent Application EP3343294A1. For example the control profile for the wafer stage of the scanner configured for a first cell die / cell structure may be defined largely independently from a control profile for a second cell / die structure positioned further along a direction of scanning. The sub-field control infrastructure allows a more optimal correction of overlay (or focus) variations being repetitive at a sub-field resolution. Further the ability to independently control different sub-field areas allows mitigation of die-to-die or cell-to-cell variations of the intra-die and/or intra-cell overlay / focus fingerprint.

Typically scanner overlay control uses dynamic stage position control to adjust placement of structures (features) such that an overlay error is minimized. In principle this may be implemented by pre-correction of an expected overlay error fingerprint (e.g., as induced by a buildup of stress due to application of a subsequent layer) and/or by adjustment of placement of features within the subsequent layer in order to sufficiently align with features in the previous layer(s).

Such a scanner control may be used in combination with other techniques such as reticle feature correction offsets. Ideally the shift would be exactly the opposite of the error shift being corrected, e.g., the feature shift due to stress induced deformation after application of the subsequent layer. The effect is that the use of such a reticle would leave much less to be corrected by the scanner overlay correction infrastructure. However, correction via the reticle is necessarily static and cannot address any variation (e.g., field-to-field, wafer-to-wafer and/or lot-to-lot variation) in the overlay fingerprint. Such variation can be of the same order of magnitude as the fingerprint itself. In addition, there are actuation and sensitivity limitations in controlling such a reticle writing correction inherent in the writing tool used (e.g., an e-beam tool or similar).

The scanner overlay correction is typically applied by the stage controller and/or lens manipulators of the projection lens (odd aberration control may be used to control placement of features). However, as already mentioned, the scanner cannot perfectly follow any desired overlay correction profile. One reason for this is due to constraints on the speed and acceleration achievable by the wafer (and reticle) stage. Another reason is the fact that the scanner exposes the substrate with a relatively large illumination spot (the so-called slit length being representative for the size of the light spot in the scanning direction, reference: EP application EP19150960.3, which is hereby incorporated by reference in its entirety). The extension of the light spot means that some part of the features within a die / cell will always be sub-optimally positioned during the scanning exposure, in situations where the desired overlay correction is not merely a simple shift across the entire die / cell. This variation of the effective position (overlay) correction during the scanning operation effectively causes a blurring of the aerial image of the features, which in turn leads to a loss of contrast. This dynamic effect is commonly referred to as Moving Standard Deviation (MSD). The limitations on the stage positioning are typically associated with the average position (overlay) error and are commonly referred to as a Moving Average (MA) error.

More specifically, the Moving Average (MA) error and Moving Standard Deviation (MSD) of the error of a lithographic stage relates to a critical time window comprising the time interval that each point on a die is exposed (in other words: receives photons). If the average position error for a point on the die during this time interval is high (in other words: high MA-error), the effect is a shift of the exposed image, resulting in overlay errors. If the standard deviation of the position error during this time interval is high (in other words: high MSD error), the image may smear, resulting in fading errors.

Both average overlay errors (MA) and contrast loss due to MSD are contributors to the overall Edge Placement Error (EPE) budget and hence need to be carefully balanced when determining a certain control profile for a wafer and/or reticle stage; typically a more MA targeted control approach will give a higher MSD impact, while an MSD targeted control strategy may lead to unacceptably large MA errors. EPE is the combined error resultant from global critical dimension uniformity (CDU), local CDU (e.g., line edge roughness LER/ line width roughness LWR) and overlay error. It is these parameters which have the greatest effect on yield, as it is errors in these parameters which effect the relative positioning of features, and whether any two features unintentionally make contact or unintentionally fail to make contact.

A number of methods for improved sub-field control to correct for intra-field fingerprints will now be described. Firstly, a method will be described for improving optimization of an intra-field correction for edge fields (or other layouts) which comprise partial dies or have patterns which do not have a uniform intra-die stress within-slit. Tooling (slit/actuation range) restricts correction capability meaning that correction for some dies will not be actuated correctly.

The optimization, for example, may comprise an intra-field "sub-field-in-spec" optimization, such as an intra-field "dies-in-spec" or "sub-dies in spec" optimization, the latter describing where the die may be further divided into sub-die regions, each being defined by being a different functional region. The functional regions may be defined and differentiated according to their intended function (e.g., memory, logic, scribe lane etc.), as these may have different process control requirements (e.g., process window and best parameter value). Another example of where a "sub-dies in spec" optimization is when a die is exposed in multiple exposures (e.g., stitched dies).

Such an intra-field "sub-field-in-spec" optimization aims to maximize the number of dies or sub-dies over the field which are within specification and therefore likely to yield a functional device, rather than applying an averaged optimization across the field (e.g., a least-squares minimization). Examples and methods for individual sub-field (e.g., die or sub-die) optimization and control are disclosed in the aforementioned European Patent Application EP3343294A1 and US20180292761. EP3343294A1 discloses various methods which may be used to actuate the correction, depending on the parameter of interest. These include tilting the reticle stage and/or wafer stage relative to each other. A curvature to the focus variation (in either direction i.e., including across the exposure slit) may be introduced via the projection lens optics (e.g., a lens manipulator), and (in the scan direction) by varying the relative tilt of reticle stage to wafer stage during exposure. Such methods and others will be readily apparent to the skilled person and will not be discussed further.

In particular, US20180292761 discloses modelling sub-fields individually, to determine individual sub-field corrections. In an embodiment, an intra-field sub-fields-in-spec optimization as described herein may comprise an intra-field dies-in-spec co-optimization of the intra-field model and sub-field model(s).

An intra-field, sub-field-in-spec (e.g., dies-in-spec) optimization can use prior knowledge of the product (the die layout) and/or measurements of the intra-field stress or intra-die stress when optimizing the parameter of interest. A least squares optimization typically treats each location within a sub-field equally, without taking into account the field/die layout. As such, a least squares optimization may prefer a correction which "only" has two locations out-of-specification, but each in a different sub-field/die, over a correction which has four locations out-of-specification, but only affecting one sub-field/die. However, as a single defect will tend to render a die defective, maximizing the number of defect-free dies (i.e., dies-in-spec) is ultimately more important than simply minimizing the number of defects per field. It should be appreciated that dies-in-spec optimization may comprise a maximum absolute (max abs) per die optimization. Such a max abs optimization may minimize the maximum deviation of the performance parameter from a control target.

The intra-field sub-field-in-spec optimization may determine an optimal sub-field control trajectory which maximizes the number of dies-in-spec based on the intra-die stress and/or actuation capability of the scanner. Edge dies, and/or dies having non-uniform (or non-symmetrical) stress tend to be difficult to correct for due to the correction capabilities within the scanner. Because of this, an optimization may allow for such dies to be sacrificed (e.g., allowing them to have a large number of defects) or otherwise weights against them or gives them lesser consideration/importance. This can be achieved in a number of ways, e.g., by giving such dies a large process window (e.g., close to or even greater than that which is viable) or otherwise weighting against parameters relating to these dies in the optimization. The decision to sacrifice or give lower weighting to a die may be made based on die and/or field location on the substrate (e.g., locations for which particularly difficult intra-die fingerprints are expected such as at the substrate edge), an expected, estimated or measured intra-die stress fingerprint (e.g., estimated from scanner metrology such as leveling data and corresponding intra-die topology- such as by using the methods which will be described later). Of course, even without such weighting strategies, a max abs optimization will tend to prefer correction for dies for which the intra-die stress is uniform and easier to correct for.

Correction capability across the width silt is particularly limited. Because of this, a single value for one or more parameters (e.g., overlay, MA or MSD) may presently be selected, which minimizes an error (e.g., a least-squares minimization) across the slit, and therefore this single value is applied for all sub-fields/dies across the slit. This is not a problem for some fields, but other fields, e.g., those near the substrate edge (comprising edge dies) and/or those comprising dies displaying significant non-uniform intra-die stress, there may be no correction available which will yield all dies across the slit/within the field. More specifically, present optimization schemes may set a single threshold for the parameter of interest (e.g., MSD) and constrain any sub-field or die from exceeding the threshold. However, in some cases it may be better to allow this threshold to be exceeded for one sub-field, if the dies-in-spec metric is improved. This may be the case if the actuation potential is insufficient to perform a correction determined to keep all sub-fields below the threshold and/or if a sub-field is relatively unimportant (e.g., an edge die or die with non-uniform stress and therefore unlikely to yield anyway).

In another embodiment, an intra-field or intra-die co-optimized correction for at least two control regimes is proposed. The control regimes may relate to, for example, different tools used in the formation of structures or integrated circuits on a substrate. In an embodiment one of the tools may be a scanner (correction in the scanner control regime). Other tools may comprise one or more of an etcher (etch control regime), baking tool (baking control regime, e.g., where a parameter may be baking time), a development tool (development control regime) and a coating or deposition tool (deposition control regime, e.g., where a parameter may be resist thickness or even a material used), for example.

Intra-die-stress and/or sub-field patterns within fields occur in large part due to process behavior. Controlling process tools will affect how, for example, intra-die stress builds up on a substrate. By tuning process tool parameters in combination with scanner corrections, fingerprints resultant from such intra-die stress can be better controlled. In particular, it is observed that sub-field correction potential of current sub-field models tend to be non-linear. Combining this with the non-linear correction potential of one or more process tools can provide for a larger correction space and more optimal corrections.

The sub-field control co-optimization may be in terms of, for example, one or more of overlay, MA and MSD. It can be a dies-in-spec or sub-field in spec optimization as described above (i.e., these embodiments can be combined and are complementary). The optimization can take into account throughput and the time for performing a certain correction. In particular, some etch corrections, while beneficial in terms of overlay or other parameters, may take a long time to actuate. Therefore, the co-optimization may balance throughput against the parameter of interest, or decide to apply such longer duration corrections only to critical regions or "hotspots". Different regions (sub-fields or sub-dies) may be assigned a different weighting between quality, e.g., overlay, MSD, EPE or other quality parameter of interest, and throughput/time to perform a corrective action. Such a weighting or balancing may be dependent, for example, "sub-field-in-spec" "sub-field-in-spec" on criticality or a corresponding process window.

In addition, intra-field and/or intra-die fingerprints can be decomposed into group fingerprints which, for example, can then be linked to context (context data). Context data may describe the processing history of a particular substrate; e.g., which process steps have been applied, which one or more individual apparatuses have been used in the performance of those steps (e.g., which etch chamber and/or deposition tool was used; and/or which scanner and/or chuck was used to expose a previous layer), and/or which parameter settings were applied by those one or more apparatuses during the processing step (for example a setting of temperature or pressure within the etching regime, or a parameter such as an illumination mode, an alignment recipe, etc. in the scanner). The intra-die and intra-field stress, and related sub-field and intra-field fingerprints (e.g., overlay fingerprints), are highly dependent on such context. Therefore, an ability to predict this stress (and consequently an appropriate correction) from the context is possible. This could be achieved, for example, by building a database or machine learned network which links such intra-field or intra-die fingerprints (e.g., overlay fingerprints) with context data. Such a library can be built from a large amount of metrology data with known context, for example.

In particular, such a technique may comprise monitoring the run to run residual of intra-field or intra-die fingerprints, e.g., measured using special reticles, which are very densely populated with targets and/or via in-die metrology techniques (metrology on targets within dies), and/or levelling/wafer shape data. These shapes/fingerprints can then be separated by any suitable means (e.g., according to a suitable KPI and/or by a component analysis technique).

In run to run (often abbreviated as run2run) control, a fingerprint (e.g., an overlay fingerprint) is estimated from a set of substrates (e.g., wafers) measured per lot. One or more measured fields from these substrates are fit to a fingerprint, and then this fingerprint is typically mixed with earlier fingerprints to create a new fingerprint estimate using an exponentially weighted moving average (EWMA) filter. Alternatively, the fingerprint may simply be updated periodically, or even measured once and held constant. A combination of some or all of these approaches is also possible. The results of this calculation are then run through an optimization job in order to set one or more scanner actuators and/or other tool actuators/settings for the next lot to reduce or minimize overlay.

The co-optimization of scanner parameters and one or more processing tool parameters may comprise an optimization of MA or MSD or of an MA / MSD combination associated with the scanner correction profile with respect to a suitable performance parameter (e.g., overlay or an expected EPE error of one or more critical features within a sub-field/die). In such an embodiment, the method may comprise identifying one or more critical features within the sub-fields and performing the co-optimization in terms of finding co-optimized settings for at least two different tools which minimizes expected overlay, MSD and/or EPE of the critical feature(s) and/or using expected overlay, MSD, and/or EPE of the critical feature(s) as the merit term in a merit function.

In another embodiment, a physical and/or empirical thru-stack model is proposed which describes how a parameter of interest, e.g., overlay or EPE, propagates through a stack (e.g., from layer to layer). This may comprise predicting/estimating the overlay through a stack at a sub-field level, taking into account that an intra-die stress fingerprint will be influenced by a number of different process fingerprints (e.g., relating to deposition and/or etching processes).

Such a thru-stack model has a number of advantages. A physical / empirical model will provide insight into overlay, e.g., a sub-field correction model can calculate residual after using sub-field corrections. Further knowledge of sub-field corrections can be merged back into the thru-stack model to better optimize stack design.

Modifying a product and/or changing a process will have an impact on intra-field and intra-die (sub-field) fingerprints. Current methods comprise optimizing the process or product and then correcting via appropriate sub-field corrections, which is a short term and expensive solution. Experimental iterations are costly and time consuming while maximizing processing time/effort are operationally expensive. Balancing lithography and process effects via such thru-stack models can speed-up research and development.

Such a thru-stack model could be used to aid implementation of the two optimization embodiments (dies-in-spec optimization and/or multiple tool co-optimization) described herein. The ability to predict the overlay through stack (in particular, caused by intra-die stress) provides potentially better dies-in spec or yield loss prediction. Also, such a model based estimation of overlay through stacks better enables the building of a fingerprint database for providing a suitable correction.

It is further proposed to optimize a control strategy based on a sensitivity metric describing the sensitivity of a particular correction to input/metrology data used to determine the correction and/or the layout of the device being exposed; e.g., the sensitivity of a control profile to the quality of metrology data (e.g. overlay data) used to determine that control profile. Sub-field corrections may be based on a parameter and/or fading optimization, where key parameters such as MSD, correction profiles and wafer stage/reticle stage jerk have impact on the overall performance of the sub-field optimization.

Such sensitivity metrics can be used, for example, to determine and/or quantify accuracy; e.g., the sensitivity metric may comprise an accuracy metric for a potential actuation input (e.g., quantifying the likely accuracy of the potential actuation). For example, an accuracy metric may indicate lower accuracy where the input data/metrology data used to determine the potential actuation input is not reliable (e.g., due to noise) and/or where the actuation potential is limited and cannot properly actuate the potential actuation input. Understanding sensitivity and variation in one or more scanner parameters (e.g., KPIs) enables improved process monitoring/control and a more accurate fingerprint determination, resulting in better scanner actuation and improve overlay and hence improved yield. For example, a different control strategy may be chosen based on the sensitivity or accuracy metric.

More specifically, the control strategy optimization may optimize, for example, a scanner-reticle co-optimization control profile, control loop time filtering and/or control loop weighting. By way of example, if it is known that metrology data is noisy then a different scanner-reticle co-optimization may be used compared to when the metrology data is less noisy. Scanner-reticle co-optimization is described in European patent application, application number EP 19177106.2, which is incorporated herein by reference, and describes the co-optimization of correction strategies for both of the reticle formation process and scanner exposure process to determine an optimized reticle correction which is such that that the co-optimized scanner correction corrects for a simpler to actuate overlay error profile in the scanning direction. The co-optimization may also take into account reticle writing tool capabilities and/or sensitivities to better optimize the reticle correction. Such a co-optimization may comprise, for example, solving an iterative algorithm which optimizes (e.g., minimizes) the performance parameter value (e.g., overlay or EPE) in terms of sub-profiles for scanner and reticle writing tool.

In addition, when choosing a relatively 'noise forgiving' control strategy, a sparser and/or simpler measurement strategy may be used. This enables the sensitivity to be controlled by controlling the metrology (e.g., by measuring more or fewer points). Sparser metrology data may also comprise scanner metrology data (in combination to supplement other metrology data or instead of other metrology data), such as levelling metrology data.

In another embodiment, a control strategy or control recipe may be derived and/or selected based on sparse (and more specifically scanner) metrology data and a library of intra-field or intra-sub-field (intra-die) fingerprints (or associated control recipes). This can significantly lessen the high computational effort involved in determining the control recipes for each process (e.g., for each wafer). A database of intra-field (and/or intra-sub-field) fingerprints, and/or associated corrections can be created for a particular field geometry, based on training data e.g., relating to relevant MSD and sub-field correction parameters. Such a database can be used to determine quick and relatively accurate correction profiles for scanner actuation, based on (e.g., inline) scanner metrology for example. By contrast, presently an actuation profile for intra-die stress induced fingerprints needs to be generated by external tooling, before corrections are sent to scanner.

For example, while all wafers have intra-die stress, and it can be difficult to understand how the stress fingerprint evolves wafer-to-wafer, as it is not possible to perform external metrology on all wafers. Presently, extensive metrology is performed to measure an intra-field, intra-sub-field or intra-die fingerprint resulting from this intra-die stress on a subset of the wafers and a correction determined, which is merged with the leveling metrology for a particular wafer and used to determine a correction. Here it is proposed to estimate the fingerprint due to intra-die stress and/or a corresponding correction using the levelling data.

As such the training data may comprise the non-scanner or external metrology data (e.g., fingerprint data comprising intra-field and/or intra-sub-field fingerprints, such as overlay fingerprint data etc. measured using a dedicated metrology tool) and corresponding scanner metrology data (e.g., levelling data) and training a suitable solver (e.g., a higher order, for example third order, equation or even a machine learning algorithm or network (e.g., an neural network)) to learn the correlation between the non-scanner/external metrology data and scanner metrology data. Using such a database, an intra-field or intra-sub-field fingerprint and/or suitable correction therefor can be determined based on the scanner metrology data, therefore enabling an in-line correction for the fingerprint (e.g., resultant, at least in part, from intra-die stress). However, it should also be appreciated that such a database or trained solver could be used in a feedback control loop or a monitoring tool (e.g., to flag particularly high stress profiles, and therefore possibly out-of-spec tooling).

Such a database linking scanner metrology to intra-field fingerprints such as those resultant from intra-die stress could be used (or combined and trained) in combination with the aforementioned database linking context to intra-field fingerprints. As such intra-field fingerprints (e.g., resultant from intra-die stress) could be determined (e.g., inline) based on both context and scanner metrology.

Furthermore, the sensitivity metric could be used in relation to current product performance (cd-ratio/litho-margin for example) to identify variation and excursions (e.g., to connect input data via the sensitivity metric to product).

The sensitivity metric can also be used as an input for time filtering methods, and APC control; weighting for example can be adjusted by sensitivity of actuation profile based on user preference and input data or based on noise level of data.

Figure 5 is a flow diagram illustrating an exemplary arrangement which combines many of the concepts described above. A training phase TP uses external metrology data DAT_{MET} and corresponding scanner metrology data DAT_{SCAN}. External metrology data DAT_{MET} may comprise, for example, fingerprint data such as intra-field fingerprints and/or optionally intra-sub-field or intra-die fingerprints (all mentions of intra-field fingerprints should be understood to encompass the possibility of smaller scale, sub-field fingerprints). Such an intra-field fingerprints may be in the form of one or more of overlay data, in-die metrology data, scanning electron microscope data, for example. Scanner metrology data DAT_{SCAN} may comprise one or more of levelling data such as levelling MA error, height map data, continuous wafer map, for example.

In the training phase TP, the external metrology data DAT_{MET} and corresponding scanner metrology data DAT_{SCAN} may be used to construct a fingerprint database FPDB which comprises, for example, said fingerprint data (e.g., as derived from the metrology data DAT_{MET} and which may comprise intra-field fingerprints resultant from intra-die stress) linked with the corresponding scanner metrology data DAT_{SCAN}. This can be done by training a suitable solver as described. The fingerprint database FPDB may also comprise suitable corrections and/or correction recipes for each intra-field fingerprint.

In a production phase PP, scanner metrology data DAT_{SCAN} from the scanner SCAN, in combination with the fingerprint database FPDB as constructed in the training phase, to infer the intra-field fingerprint as part of an optimization step OPT. This inference can be supported and/or validated using external metrology data DAT_{MET} from a metrology tool DAT. As this metrology data DAT_{MET} is used only or mainly for validation of the intra-field (e.g., stress) fingerprint inferred via scanner metrology DAT_{SCAN}, rather than to actually determine the intra-field fingerprint, it can be significantly sparser (fewer measurements e.g., at fewer locations and/or using fewer wafers) than many present metrology strategies. Alternatively or in addition, the metrology data can be targeted, e.g., based on the determined intra-field/intra-die fingerprint. For example, the measurements can be targeted to regions or locations where the fingerprint shows a particularly large error or residual indicative of the intra-die stress being particularly large (e.g., compared to the rest of the die).

The optimization step OPT may further comprise determining a sensitivity metric, e.g., to determine sensitivity of the parameter of interest (e.g., the KPI), and use this to optimize for the correction. The determining of a sensitivity metric may use any of the methods described herein.

As described above, the optimization step OPT may be a co-optimization for control of the scanner SCAN and another tool (e.g., etcher ETCH).

As described above, the optimization step OPT may be a dies-in-spec or sub-field in spec optimization.

As described above, the optimization step OPT may use a thru-stack model to take into account the effects of previous layers when optimizing.

The output OUT therefore may comprise one or more of:
- an estimate of an intra-field and/or intra-sub-field/intra-die fingerprint such as that resultant (at least in part) from intra-die stress, without direct measurement (e.g., per wafer)- this can be verified by (e.g., limited or sparse) metrology;
- an optimized metrology scheme (e.g., sampling scheme) with sparse and/or targeted measurements;
- optimized correction e.g., using the intra-field and/or intra-die stress fingerprint thereby reducing lead time and metrology cost;
- evolution data tracking the evolution of the intra-die fingerprints over time/fields/wafers/lots.

Such an arrangement therefore enables a per-wafer intra-die fingerprint (e.g., due to stress) monitoring feature, the results of which (and the evolution of the fingerprint over time/fields/wafers/lots) may be used to further fine tune process control. The arrangement also provides for more efficient metrology, reducing performance of unnecessary metrology and also provides guidance for the metrology to the point of interest where intra-die stress is more severe. Furthermore, the arrangement facilitates monitoring of the applied scanner correction for the intra-field stress fingerprint; e.g., to monitor how good the applied actuation is in terms of on-product performance.

Using such a database, an intra-field fingerprint and/or suitable correction therefor can be determined based on the scanner metrology data, therefore enabling an in-line correction for intra-die stress.

The following numbered clauses comprise concepts disclosed herein, wherein each may be implemented as a computer program and/or within a lithographic apparatus suitably configured:
1. A method for determining an intra-field correction for sub-field control of a lithographic process for exposing a pattern on an exposure field of a substrate, the exposure field comprising a plurality of sub-fields, the method comprising performing an optimization to determine the intra-field correction, said optimization being such that it maximizes the number of said sub-fields which are within specification.
2. A method as described in clause 1, wherein said performing an optimization comprises weighting against and/or sacrificing one or more sub-fields which are considered to have a higher likelihood of being non-functional
3. A method as described in clause 2, wherein the decision to weight against and/or sacrifice one or more sub-fields is based on prior knowledge of the product being exposed.
4. A method as described in clause 2 or 3, wherein the decision to weight against and/or sacrifice one or more sub-fields is based on measurements of stress within the field.
5. A method as described in clause 4, wherein sub-fields showing higher levels of non-uniformity for said stress are more likely to be weighted against and/or sacrificed.
6. A method as described in clause 5, wherein the determination of higher levels of non-uniformity is based on whether stress uniformity for the die is above a stress uniformity threshold value.
7. A method as described in any of clauses 2 to 6, wherein the decision to weight against and/or sacrifice one or more sub-fields is based on the location of the field and/or sub-field on the substrate.
8. A method as described in clause 7, wherein sub-fields at or near the edge of the substrate are more likely to be weighted against and/or sacrificed.
9. A method as described in any preceding clause, wherein the optimization comprises a maximum absolute per sub-field optimization.
10. A method as described in any preceding clause, wherein said optimization determines an optimal sub-field control trajectory which maximizes the number of sub-fields within specification.
11. A method as described in any preceding clause, wherein said optimization takes into account an actuation capability of the lithographic apparatus used to perform the lithographic process.
12. A method as described in any preceding clause, wherein each sub-field comprises a single die or part thereof.
13. A method as described in any preceding clause, wherein said determining an intra-field correction comprises correcting at least in part for an intra-sub-field and/or intra-field fingerprint related to a stress pattern within the sub-field or field.
14. A method for determining an intra-field correction for sub-field control of a manufacturing process comprising a lithographic process for exposing a pattern on an exposure field of a substrate, the exposure field comprising a plurality of sub-fields, the manufacturing process comprising at least one additional processing step, the method comprising:
   - performing an optimization to determine the intra-field correction, said optimization comprising co-optimizing in terms of at least one lithographic parameter relating to the lithographic process and at least one process parameter relating to the at least one additional processing step.
15. A method as described in clause 14, wherein the at least one lithographic parameter relates to control of a lithographic apparatus used to perform the lithographic process and at least one process parameter relates to control of at least one processing apparatus used to perform the at least one additional processing step.
16. A method as described in clause 15, wherein the at least one processing apparatus comprises one or more of an etch apparatus or chamber thereof, a deposition apparatus, a baking apparatus, a development apparatus, and a coating apparatus.
17. A method as described in any of clauses 14 to 16, wherein said optimization is in terms of, one or more of edge placement error, overlay, moving average error and moving standard deviation error.
18. A method as described in any of clauses 14 to 16, wherein said optimization is in terms of a maximization of the number of said sub-fields which are within specification.
19. A method as described in clause 18, wherein said optimization comprises performing the method of any of clauses 1 to 13.
20. A method as described in any of clauses 14 to 19, wherein said optimization comprises a balance between throughput and quality.
21. A method as described in clause 20, wherein said balance between throughput and quality is weighted differently for different sub-fields.
22. A method as described in any of clauses 14 to 21, wherein said determining an intra-field correction comprises correcting at least in part for an intra-sub-field and/or intra-field fingerprint related to a stress pattern within the sub-field or field; and said method comprises:
   - predicting an intra-sub-field and/or intra-field fingerprint from context data describing the processing context of a substrate; and
   - wherein said determining an intra-field correction comprises determining a correction based on said predicted intra-sub-field and/or intra-field fingerprint.
23. A method as described in clause 22, wherein said step of determining a correction based on said predicted intra-sub-field and/or intra-field fingerprint comprises referring to a library linking group fingerprints to said context data for a plurality of substrates.
24. A method as described in clause 23, wherein said method further comprises the initial steps of:
   - obtaining fingerprint data describing said intra-sub-field and/or intra-field fingerprints for the plurality of substrates and corresponding context data describing a processing history of each substrate;
   - decomposing said intra-field and/or intra-sub-field fingerprints into group fingerprints; and
   - compiling said library linking said group fingerprints to said context data.
25. A method for determining an intra-field correction for sub-field control of a lithographic process for exposing a pattern on an exposure field of a substrate in a number of layers forming a stack, the exposure field comprising a plurality of sub-fields, the method comprising
   - constructing a physical and/or empirical thru-stack model which describes how a parameter of interest, propagates from layer to layer through the stack.
26. A method as described in clause 25, comprising using said model to estimate evolution of the parameter of interest through the stack at a sub-field level.
27. A method as described in clause 25 or 26, comprising using said model to calculate a residual error after actuating the intra-field correction.
28. A method as described in any of clauses 25 to 27, comprising using said thru-stack model in said compiling said library in the method of clause 24.
29. A method as described in any of clauses 25 to 27, comprising using said thru-stack model to predict values for the parameter of interest; and using said predicted values in said step of performing an optimization in the method of any of clauses 1 to 13.
30. A method for determining an intra-field correction for sub-field control of a lithographic process for exposing a pattern on an exposure field of a substrate, the exposure field comprising a plurality of sub-fields, the method comprising: determining a sensitivity metric describing the sensitivity of a correction to input data used to determine the correction and/or the layout of said pattern; and determining said intra-field correction for sub-field control based on said sensitivity metric.
31. A method as described in clause 30, wherein said sensitivity metric describes the accuracy of a potential actuation input.
32. A method as described in clause 31, wherein said sensitivity metric indicates a lower accuracy where the input data is not reliable and/or where the actuation potential is limited and cannot properly actuate the potential actuation.
33. A method as described in any of clauses 30 to 32, wherein said step of determining said intra-field correction comprises optimizing on or more of a scanner-reticle co-optimization control profile, control loop time filtering and/or control loop weighting.
34. A method as described in any of clauses 30 to 33, further comprising using the sensitivity metric to select a control strategy from a library of control strategies, based on lithographic apparatus metrology data.
35. A method as described in any of clauses 30 to 33, further comprising using the sensitivity metric to select a control strategy using a trained solver, based on lithographic apparatus metrology data.
36. A method as described in clause 35, comprising: obtaining training data comprising non-lithographic apparatus metrology data and corresponding lithographic apparatus metrology data from a plurality of substrates; and training said solver to link said non-lithographic apparatus metrology data and said lithographic apparatus metrology data.
37. A method as described in any of clauses 34 to 36, wherein said lithographic apparatus metrology data comprises leveling data.
38. A method as described any of clauses 30 to 37, comprising determining an estimate for intra-die stress from the levelling data; and determining a correction based on the estimated intra-die stress.
39. A method as described in clause 38, wherein said steps of determining an estimate and determining a correction are performed for each die, based on leveling data from each substrate.
40. A method for determining an intra-field correction for sub-field control of a lithographic process for exposing a pattern on an exposure field of a substrate, the exposure field comprising a plurality of sub-fields, the method comprising:
   obtaining a database comprising intra-field fingerprint data linked with historic lithographic apparatus metrology data;
   determining an estimate for an intra-field fingerprint from lithographic apparatus metrology data and said database; and
   determining the intra-field correction for the lithographic process based on the estimated intra-field fingerprint.
41. A method according to clause 40, wherein said intra-field fingerprint data comprises intra-field fingerprints related to a stress pattern within each field.
42. A method according to clause 40 or 41, wherein said intra-field fingerprint data comprises intra-sub-field fingerprints related to a stress pattern within each sub-field.
43. A method according to any of clauses 39 to 42, comprising obtaining external metrology data from earlier substrates; and
   validating the intra-field correction based on said external metrology data.
44. A method according to clause 43, wherein said external metrology data is sparser than that would be necessary to directly determine said intra-field correction.
45. A method according to clause 43 or 44, comprising using said estimate for an intra-field fingerprint to determine a metrology strategy for said external metrology.
46. A method according to clause 45, wherein said determining a metrology strategy comprises determining a sampling scheme for said external metrology.
47. A method according to any of clauses 39 to 46, comprising monitoring the relationship between said estimate for an intra-field fingerprint and said intra-field correction.
48. A method according to any of clauses 39 to 47, wherein said determining an intra-field correction comprises performing an optimization for at least one parameter of interest.
49. A method according to clause 48, wherein said optimization is such that it maximizes the number of said sub-fields which are within specification.
50. A method according to clause 49, wherein the optimization comprises a maximum absolute per sub-field optimization.
51. A method according to clause 49 or 50, wherein said performing an optimization comprises weighting against and/or sacrificing one or more sub-fields which are considered to have a higher likelihood of being non-functional.
52. A method according to clause 51, wherein the decision to weight against and/or sacrifice one or more sub-fields is based on prior knowledge of the product being exposed.
53. A method according to clause 51 or 52, wherein the decision to weight against and/or sacrifice one or more sub-fields is based on said estimate for an intra-field fingerprint.
54. A method according to clause 53, wherein, where said estimate for an intra-field fingerprint indicates one or more non-uniform sub-fields showing higher levels of non-uniformity for intra-sub-field stress, these non-uniform sub-fields are weighted against and/or sacrificed.
55. A method according to clause 54, wherein the determination of higher levels of non-uniformity is based on a determination of whether the intra-sub-field stress uniformity for the sub-field is above a stress uniformity threshold value.
56. A method according to any of clauses 51 to 55, wherein the decision to weight against and/or sacrifice one or more sub-fields is based on the location of the field and/or sub-field on the substrate.
57. A method according to clause 56, wherein sub-fields at or near the edge of the substrate are more likely to be weighted against and/or sacrificed.
58. A method according to any of clauses 49 to 57, wherein said optimization determines an optimal sub-field control trajectory which maximizes the number of sub-fields within specification.
59. A method according to any of clauses 48 to 58, wherein said optimization takes into account an actuation capability of the lithographic apparatus used to perform the lithographic process.
60. A method according to any of clauses 48 to 59, wherein said parameter of interest comprises one or more of edge placement error, overlay, moving average error and moving standard deviation error.
61. A method according to any of clauses 48 to 60, wherein said optimization comprises co-optimizing in terms of at least two of said parameters of interest comprising at least one lithographic parameter relating to the lithographic process and at least one process parameter relating to the at least one additional processing step.
62. A method according to clause 61, wherein the at least one lithographic parameter relates to control of a lithographic apparatus used to perform the lithographic process and at least one process parameter relates to control of at least one processing apparatus used to perform the at least one additional processing step.
63. A method according to clause 62, wherein the at least one processing apparatus comprises one or more of an etch apparatus or chamber thereof, a deposition apparatus, a baking apparatus, a development apparatus, and a coating apparatus.
64. A method according to any of clauses 48 to 63, comprising the step of constructing a physical and/or empirical thru-stack model which describes how a parameter of interest propagates through a stack being formed on the substrate in a number of layers;
   using said thru-stack model to estimate evolution of the parameter of interest through the stack at a sub-field level; and
   using said estimate of evolution of a parameter of interest through the stack in said optimization.
65. A method according to clause 64, comprising using said thru-stack model to calculate a residual error after actuating the intra-field correction;
   and using said residual error in a subsequent optimization for an intra-field correction.
66. A method according to clause 64 or 65, comprising using said thru-stack model to predict values for the parameter of interest; and
   using said predicted value in said step of determining the intra-field correction.
67. A method according to any of clauses 48 to 66, comprising determining a sensitivity metric describing the sensitivity of a correction to input data used to determine the intra-field correction and/or the layout of said pattern; and
   using said sensitivity metric in said optimization step.
68. A method according to clause 67, wherein said sensitivity metric describes the accuracy of a potential actuation input.
69. A method according to clause 68, wherein said sensitivity metric indicates a lower accuracy where the input data is not reliable and/or where the actuation potential is limited and cannot properly actuate the potential actuation.
70. A method according to any of clauses 67 to 69, wherein said step of determining said intra-field correction comprises optimizing on or more of a scanner-reticle co-optimization control profile, control loop time filtering and/or control loop weighting.
71. A method according to any of clauses 67 to 70, further comprising using the sensitivity metric to select a control strategy from a library of control strategies, based on said lithographic apparatus metrology data.
72. A method according to clause 40, wherein said step of determining an intra-field correction is further based on a database linking group fingerprints to context data.
73. A method according to any of clauses 39 to 72, wherein each sub-field comprises a single die or part thereof.
74. A method according to any of clauses 39 to 73, further comprising using estimate for an intra-field fingerprint to select a control strategy from a library of control strategies, based on lithographic apparatus metrology data.
75. A method according to any of clauses 39 to 74, further comprising:
   obtaining training data comprising external metrology data and/or intra-field fingerprints derived therefrom and corresponding lithographic apparatus metrology data from a plurality of substrates; and
   training said solver to link said external metrology data and/or intra-field fingerprints to said lithographic apparatus metrology data.
76. A method according to any of clauses 39 to 75, wherein said lithographic apparatus metrology data comprises leveling data.
77. A method according to any of clauses 39 to 76, wherein said steps of determining an estimate for an intra-field fingerprint and determining the intra-field correction are performed per substrate.
78. A method according to any of clauses 39 to 77, wherein said steps of determining an estimate for an intra-field fingerprint and determining the intra-field correction are performed per field and/or per sub-field.
79. A method according to any of clauses 39 to 78, comprising monitoring the evolution of the intra-field fingerprint data over time, wafers and/or lots.
80. A method for determining an intra-field correction for sub-field control of a lithographic process for exposing a pattern on an exposure field of a substrate, the exposure field comprising a plurality of sub-fields, the method comprising:
   performing an optimization to determine the intra-field correction, said optimization being such that it maximizes the number of said sub-fields which are within specification.
81. A method for determining an intra-field correction for sub-field control of a manufacturing process comprising a lithographic process for exposing a pattern on an exposure field of a substrate, the exposure field comprising a plurality of sub-fields, the manufacturing process comprising at least one additional processing step, the method comprising:
   performing an optimization to determine the intra-field correction, said optimization comprising co-optimizing in terms of at least one lithographic parameter relating to the lithographic process and at least one process parameter relating to the at least one additional processing step.
82. A method for determining an intra-field correction for sub-field control of a lithographic process for exposing a pattern on an exposure field of a substrate in a number of layers forming a stack, the exposure field comprising a plurality of sub-fields, the method comprising constructing a physical and/or empirical thru-stack model which describes how a parameter of interest, propagates from layer to layer through the stack.
83. A method for determining an intra-field correction for sub-field control of a lithographic process for exposing a pattern on an exposure field of a substrate, the exposure field comprising a plurality of sub-fields, the method comprising:
   determining a sensitivity metric describing the sensitivity of a correction to input data used to determine the correction and/or the layout of said pattern; and
   determining said intra-field correction for sub-field control based on said sensitivity metric.
84. A computer program comprising program instructions operable to perform the method of any of clauses 40 to 83 when run on a suitable apparatus.
85. A non-transient computer program carrier comprising the computer program of clause 84.
86. A lithographic apparatus operable to perform the method of any of clauses 40 to 83; and use said correction in a subsequent exposure.

Although patterning devices in the form of a physical reticle have been described, the term "patterning device" in this application also includes a data product conveying a pattern in digital form, for example to be used in conjunction with a programmable patterning device.

Although specific reference may have been made above to the use of embodiments of the invention in the context of optical lithography, it will be appreciated that the invention may be used in other applications, for example imprint lithography, and where the context allows, is not limited to optical lithography. In imprint lithography, a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used in relation to the lithographic apparatus encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method for determining an intra-field correction for sub-field control of a lithographic process for exposing a pattern on an exposure field of a substrate, the exposure field comprising a plurality of sub-fields, the method comprising:
obtaining a database comprising intra-field fingerprint data linked with historic lithographic apparatus metrology data;
determining an estimate for an intra-field fingerprint from lithographic apparatus metrology data and said database; and
determining the intra-field correction for the lithographic process based on the estimated intra-field fingerprint.

2. A method as claimed in claim 1, wherein said intra-field fingerprint data comprises intra-field fingerprints related to a stress pattern within each field.

3. A method as claimed in claim 1 or 2, wherein said intra-field fingerprint data comprises intra-sub-field fingerprints related to a stress pattern within each sub-field.

4. A method as claimed in any preceding claim, comprising obtaining external metrology data from earlier substrates; and
validating the intra-field correction based on said external metrology data.

5. A method as claimed in claim 4, comprising using said estimate for an intra-field fingerprint to determine a metrology strategy for said external metrology.

6. A method as claimed in claim 5, wherein said determining a metrology strategy comprises determining a sampling scheme for said external metrology.

7. A method as claimed in any preceding claim, comprising monitoring the relationship between said estimate for an intra-field fingerprint and said intra-field correction.

8. A method as claimed in any preceding claim, wherein said determining an intra-field correction comprises performing an optimization for at least one parameter of interest, wherein said optimization is such that it maximizes the number of said sub-fields which are within specification.

9. A method as claimed in claim 8, wherein said optimization takes into account an actuation capability of the lithographic apparatus used to perform the lithographic process.

10. A method as claimed in claim 8 or 9, wherein said optimization comprises co-optimizing in terms of at least two of said parameters of interest comprising at least one lithographic parameter relating to the lithographic process and at least one process parameter relating to the at least one additional processing step.

11. A method as claimed in claim 10, wherein the at least one lithographic parameter relates to control of a lithographic apparatus used to perform the lithographic process and at least one process parameter relates to control of at least one processing apparatus used to perform the at least one additional processing step.

12. A method as claimed in any of claims 8 to 11, comprising the step of constructing a physical and/or empirical thru-stack model which describes how a parameter of interest propagates through a stack being formed on the substrate in a number of layers;
using said thru-stack model to estimate evolution of the parameter of interest through the stack at a sub-field level; and
using said estimate of evolution of a parameter of interest through the stack in said optimization.

13. A method as claimed in any of claims 8 to 12, comprising determining a sensitivity metric describing the sensitivity of a correction to input data used to determine the intra-field correction and/or the layout of said pattern; and
using said sensitivity metric in said optimization step.

14. A method according to any preceding claim, wherein said step of determining an intra-field correction is further based on a database linking group fingerprints to context data.

15. A method according to any preceding claim, further comprising using the estimate for an intra-field fingerprint to select a control strategy from a library of control strategies, based on lithographic apparatus metrology data.
